# EUROPEAN PATENT SPECIFICATION

(11) **EP 2 996 168 B1**
(45) Date of publication and mention of the grant of the patent: **07.10.2020**
(21) Application number: 15182174.1
(22) Date of filing: 24.08.2015
(51) Int. Cl.: H01L 51/52

(54) **ORGANIC ELECTROLUMINESCENT DEVICE AND DISPLAY HAVING THE SAME**
ORGANISCHE ELEKTROLUMINESZENTE VORRICHTUNG UND ANZEIGE DAMIT
DISPOSITIF ÉLECTROLUMINESCENT ORGANIQUE ET AFFICHAGE UTILISANT CELUI-CI

(30) Priority: 12.09.2014 CN 201410464474
(43) Date of publication of application: 16.03.2016
(73) Proprietor: EverDisplay Optronics (Shanghai) Limited, Shanghai City, Shanghai 201500 (CN)
(72) Inventor: Zhu, Wenxiu, 201500 Shanghai City (CN); Tsou, Chungche, 201500 Shanghai City (CN); Huang, Chuwan, 201500 Shanghai City (CN); Gao, Yanpin, 201500 Shanghai City (CN)
(74) Representative: Clarenbach, Carl-Philipp

(56) References cited:
- EP-A1- 2 495 783
- US-A1- 2009 032 096
- US-A1- 2011 114 973
- CHEN B J ET AL: "Transparent organic light-emitting devices with LiF/Mg:Ag cathode", OPTICS EXPRESS, OSA (OPTICAL SOCIETY OF AMERICA), WASHINGTON DC, (US), vol. 13, no. 3, 7 February 2005 (2005-02-07), pages 937-941, XP002385529, ISSN: 1094-4087, DOI: 10.1364/OPEX.13.000937

## Description

### TECHNICAL FIELD

The present disclosure generally relates to an organic electroluminescent device (OLED), and more particularly to an organic electroluminescent device which is capable of suppressing blue lights.

### BACKGROUND

Studies have shown that blue lights with wavelengths below 435nm do great harm to retinas. Human retinas contain a component called A2E whose absorption peaks appear at an ultraviolet light of 335nm and a visible blue light of 435nm, which makes the retinas be able to absorb blue lights and thus be photo-oxidized, then leads cells to be apoptotic, and then results in maculopathy of human eyes. In addition, blue lights have relatively short wavelengths and thus tend to generate scattering glare, so eyes must be focused hard, which results in fatigue and soreness of ciliary muscles and, after a long time, even pseudo myopia.

Existing OLED devices may emit blue lights with wavelengths below 435nm at a certain degree of intensity, which have been widely equipped in 3C products (computers, communications and consumer electronics) for daily lives. Accordingly, long time using such products may harm human eyes seriously and jeopardize human health.

To avoid high-energy blue lights damaging human bodies, an existing method is to paste a blue light resistant film on a 3C product. However, although the blue light resistant film may suppress part of high-energy blue lights, transmissivities of lights of all wavelengths may decrease, such that brightness of filmed products may be affected to a certain extent.

EP2495783A1 discloses an organic light-emitting device where an inorganic layer is mentioned.

US20110114973A1 discloses an organic light-emitting device where an inorganic protective layer is mentioned.

Chen B J ET AL: "Transparent organic light-emitting devices with LiF/Mg: Ag cathode", OPTICS EXPRESS, OSA (OPTICAL SOCIETY OF AMERICA), WASHINGTON DC, (US), vol. 13, no. 3, 7 February 2005 (2005-02-07), pages 937-941, XP002385529, ISSN: 1094-4087, DOI: 10.1364/OPEX. 13.000937, discloses several material used in manufacturing organic light-emitting devices.

### SUMMARY

The present invention is defined by the features of claim 1. In order to, in part, solve the above problems, according to a first aspect of embodiments of the present disclosure, there provides an organic electroluminescent device including: a first electrode layer; an organic functional layer, disposed on the first electrode layer; a second electrode layer, disposed on the organic functional layer; and an inorganic layer, disposed on the second electrode layer, wherein the inorganic layer is a titanium dioxide layer or a silicon carbide layer.

According to a second aspect of embodiments of the present disclosure, there provides a display including the organic electroluminescent device of the first aspect of embodiments of the present disclosure.

The organic electroluminescent device of the present disclosure may effectively suppress blue and violet lights that do harm to human eyes, and prevents human bodies from damages caused by high-energy blue lights. Meanwhile, the inorganic layer may function as a protection on the cover layer and the second electrode layer, so as to prolong the lifetime of the OLED device, and the micro-cavity structures of the inorganic layer and the organic material together may improve the color purity of the OLED device.

### BRIEF DESCRIPTION OF THE DRAWINGS

Figure 1 is a schematic structural view of an OLED according to an embodiment of the present disclosure;
Figure 2 shows spectrograms of OLEDs of a first embodiment to a third embodiment and a first comparative example to a third comparative example of the present disclosure; and
Figure 3 shows spectrograms of OLEDs of a fourth embodiment to a sixth embodiment and a first comparative example to a third comparative example of the present disclosure.

### DETAILED DESCRIPTION

Exemplary embodiments embodying characteristics and advantages of the present disclosure will be set forth in detail in the following description.

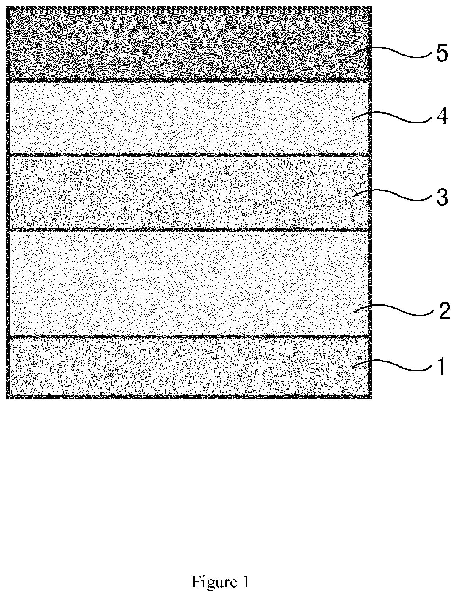

As shown in Figure 1, an organic electroluminescent device according to an embodiment of the present disclosure includes: a first electrode layer 1, which may be an anode layer; an organic functional layer 2, disposed on the first electrode layer 1; a second electrode layer 3, which may be a cathode layer, disposed on the organic functional layer 2; an inorganic layer 5, disposed on the second electrode layer 3, and a cover layer 4, disposed between the second electrode layer 3 and the inorganic layer 5.

The first electrode layer 1 may be formed on a substrate by vacuum evaporation, and may be an indium tin oxide (ITO) layer, an indium zinc oxide layer, a tin oxide or a zinc oxide layer, for example an ITO/Ag/ITO composite electrode. The thickness of the first electrode layer 1 may be 1nm ∼ 500nm, for example 30nm ∼ 100nm.

The organic functional layer 2 may include a hole injection layer, a hole transport layer, a light emitting layer, an electron transport layer and an electron injection layer disposed sequentially.

The hole injection layer may be formed on the first electrode layer 1 by vacuum evaporation of an aromatic amine compound or a star type amine. Materials for forming the hole injection layer may specifically include: 4,4',4"-tris (N-3-methylphenyl-N-phenyl-amino)-triphenylamine(m-MTDATA), 1,3,5-tris [4-(3-methyl-phenyl-phenyl-amino) phenyl] benzene(m-MTDATB) and copper phthalocyanine (CuPc). Materials for forming the hole injection layer may also be HAT-CN(Dipyrazino[2,3-f:2',3'-h]quinoxaline-2,3,6,7,10,11-hexacarbonitrile). The thickness of the hole injection layer may be 1nm ∼ 200nm, for example 90nm ∼ 120nm.

The hole transport layer may be formed on the hole injection layer by vacuum evaporation. Material of the hole transport layer may be an arylene diamine derivative, a starburst-type compound, a biphenyl diamine derivative having a spiro group, or a ladder compound, specifically N,N'-diphenyl-N,N'-bis(3-methylphenyl)-1, 1'-biphenyl-4,4'-diamine(TPD), N,N'-bis-[(1-naphthyl)-N,N'-diphenyl-1,1'-biphenyl] 4,4-diamine (NPB). The thickness of the hole transport layer may be 1nm ∼ 200nm, for example 5nm ∼ 100nm.

The light emitting layer may be formed on the hole transport layer by vacuum evaporation. Material of the light emitting layer may be one selected from a metal-organic complexe (such as Alq3 (tris (8-hydroxyquinoline) aluminum)), a polycyclic aromatic compound (such as rubrene), a phenanthroline compound and a carbazole derivative; or the material for light emitting may be mixed with fluorescent and phosphorescent dye. Specifically, a main material may include CBP (4,4-N,N-two carbazole-biphenyl) and derivatives thereof, mCP (N, N-two carbazolyl 3,5-benzene) and derivatives thereof, and dopant materials may include phosphorescent organic metal complexes having central metal atoms selected from Ir, Pt, Tb and Eu. The phosphorescent organic metal complexes include PQIr, PQIr (acac), PQ2Ir (acac), PIQIr (acac) and PtOEP. Wherein, the material for emitting blue light may be DPVBi (4,4'-bis (2,2-diphenyl vinyl)-1,1'-biphenyl): 5% BCzVB (1,4-two [2-(3-N-ethyl carbazolyl)-vinyl]-benzene). The thickness of the light emitting layer may be 5nm ∼ 50nm, for example 10nm ∼ 40nm, more for example 15nm ∼ 30nm.

The electron transport layer may be formed on the light emitting layer by vacuum evaporation. Material of the electron transport layer may be triazines, such as 4,4-bis [2-(4,6-diphenyl-1,3,5-triazinyl)]-1,1'-biphenyl, 2,4,6-tris (4-biphenylyl)-1,3,5-triazine; and the material may also be an anthracene compound, a phenanthrene compound, a fluoranthene compound, an oxadiazole compound or a vinylidene compound. The thickness of the electron transport layer may be 1nm ∼ 200nm, for example 5nm ∼ 100nm.

The electron injection layer may be formed on the electron transport layer by vacuum evaporation. Materials of the electron injection layer may include 8-hydroxyquinoline-lithium (Liq), or four (8-quinolinol) lithium boron (LiBq4), and the like. The thickness of the electron injection layer may be 1nm ∼ 200nm, for example 5nm ∼ 100nm.

The second electrode layer 3 may be formed on the organic functional layer 2 by vacuum evaporation, and it may be a metal, an alloy, or a composite electrode of metal fluoride and metal. The metal may be selected from lithium, magnesium, aluminum, calcium, strontium or indium. The alloy is alloyed by one of lithium, magnesium, aluminum, calcium, strontium and indium and one of copper, gold and silver. The thickness of the second electrode layer 3 may be 10nm ∼ 500nm.

The cover layer 4 may be formed on the second electrode layer 3 by vacuum evaporation. Material of the cover layer 4 may be selected from Alq3, Bphen (4,7-diphenyl-1,10-phenanthroline) or BCP (2,9-dimethyl-4,7-diphenyl-1,10-phenan throline). The thickness of the cover layer 4 is 40nm ∼ 80nm, for example 60nm.

The inorganic layer 5 may be formed by thermal evaporation. Material of the inorganic layer 5 is titanium oxide or silicon carbide. The thickness of the inorganic layer 5 is 10nm ∼ 20nm, for example 15nm.

The cover layer is formed of an organic material, and has a poor capacity to block water and oxygen, so that the lifetime of the OLED device is relatively short. Since a stable inorganic layer is provided on top of the OLED, not only the cover layer and the cathode layer may be protected and the lifetime of the device is prolonged, but also the micro-cavity structures of the inorganic layer and the organic material together may improve the color purity of the device and suppress blue and violet lights that do harm to human eyes.

In the present disclosure, materials and forming manners of each layer are not limited to the above described. Hereinafter, the organic electroluminescent device of the present disclosure will be further described through embodiments, wherein preparation methods in each embodiment are the same, each layer is formed by vacuum evaporation, all the materials adopted are commercially available.

### The First Embodiment

An ITO film, an Ag film, an ITO film are formed on a glass substrate sequentially, such that the ITO/Ag/ITO composite film functions as an anode;
HAT-CN is vacuum evaporated onto the anode layer to form the hole injection layer;
a NPB film, as a hole transport layer, is formed on the hole injection layer;
a mixture of DPVBi: 5% BCzVB is vacuum evaporated onto the hole transport layer to form a blue light emitting layer;
Alq3 is vacuum evaporated onto the light emitting layer to form an Alq3 layer to function as an electron transport layer;
Liq is vacuum evaporated onto the electron transport layer to form a Liq layer to function as an electron injection layer;
a Mg/Ag layer, as a cathode layer, is formed on the electron injection layer;
an Alq3 cover layer is formed on the cathode layer; and
a titanium dioxide layer is formed on the cathode layer so as to fulfill an OLED that emits blue lights, that is, and the structure of the OLED is as follows:
ITO(315nm)/HAT-CN(100nm)/NPB(20nm)/DPVBi:BCzVB(25nm)/Alq 3(35nm)/ Liq(100nm)/Mg(15nm)/Alq3(60nm)/TiO2(15nm).

### The Second Embodiment

The preparation method of the OLED of the second embodiment is the same as that of the first embodiment, therefore, description of the same technical content is omitted. In the second embodiment, a green light emitting layer is formed by mixing Quinacridone with Alq3, and the structure of the OLED is as follows:

ITO(200nm)/HAT-CN(150nm)/NPB(10nm)/Qui:Alq3(20nm)/Alq3(50n m)/Liq(100nm)/Mg(10nm)/Alq3(60nm)/TiO2(15nm).

### The Third Embodiment

The preparation method of the OLED of the third embodiment is the same as that of the first embodiment, therefore, description of the same technical content is omitted. In the third embodiment, a red light emitting layer is formed by mixing DCJTB with Alq3, and the structure of the OLED is as follows:

ZnO(150nm)/m-MTDATA(150nm)/NPB(10nm)/DCJTB:Alq3(20nm)/Al q3(50nm)/LiBq4(150nm)/Mg(10nm)/BCP(60nm)/TiO2(15nm).

### The Fourth Embodiment

The preparation method and raw materials adopted by the OLED of the fourth embodiment are the same as those of the first embodiment, therefore, description of the same technical content is omitted. The difference between the fourth embodiment and the first embodiment only lies in that the inorganic layer of the fourth embodiment is a silicon carbide layer, and the structure of the OLED of the fourth embodiment is as follows:

ITO(315nm)/HAT-CN(100nm)/NPB(20nm)/DPVBi:BCzVB(25nm)/Alq 3(35nm)/Liq(100nm)/Mg(15nm)/Alq3(60nm)/SiC(15nm).

### The Fifth Embodiment

The preparation method and raw materials adopted by the OLED of the fifth embodiment are the same as those of the second embodiment, therefore, description of the same technical content is omitted. The difference between the fifth embodiment and the second embodiment only lies in that the inorganic layer of the fifth embodiment is a silicon carbide layer, and the structure of the OLED of the fifth embodiment is as follows:
ITO(200nm)/HAT-CN(150nm)/NPB(10nm)/Qui:Alq3(20nm)/Alq3(50n m)/Liq(100nm)/Mg(10nm)/Alq3(60nm)/SiC(15nm).

### The Sixth Embodiment

The preparation method and raw materials adopted by the OLED of the sixth embodiment are the same as those of the third embodiment, therefore, description of the same technical content is omitted. The difference between the sixth embodiment and the third embodiment only lies in that the inorganic layer of the sixth embodiment is a silicon carbide layer, and the structure of the OLED of the sixth embodiment is as follows:
ZnO(150nm)/m-MTDATA(150nm)/NPB(10nm)/DCJTB:Alq3(20nm)/Al q3(50nm)/LiBq4(150nm)/Mg(10nm)/BCP(60nm)/SiC(15nm).

### The First Comparative Example

The preparation method and raw materials adopted by the OLED of the first comparative example are the same as those of the first embodiment, therefore, description of the same technical content is omitted. The difference between the first comparative example and the first embodiment only lies in that the first comparative example lacks the titanium dioxide layer.

### The Second Comparative Example

The preparation method and raw materials adopted by the OLED of the second comparative example are the same as those of the second embodiment, therefore, description of the same technical content is omitted. The difference between the second comparative example and the second embodiment only lies in that the second comparative example lacks the titanium dioxide layer.

### The Third Comparative Example

The preparation method and raw materials adopted by the OLED of the third comparative example are the same as those of the third embodiment, therefore, description of the same technical content is omitted. The difference between the third comparative example and the third embodiment only lies in that the third comparative example lacks the titanium dioxide layer.

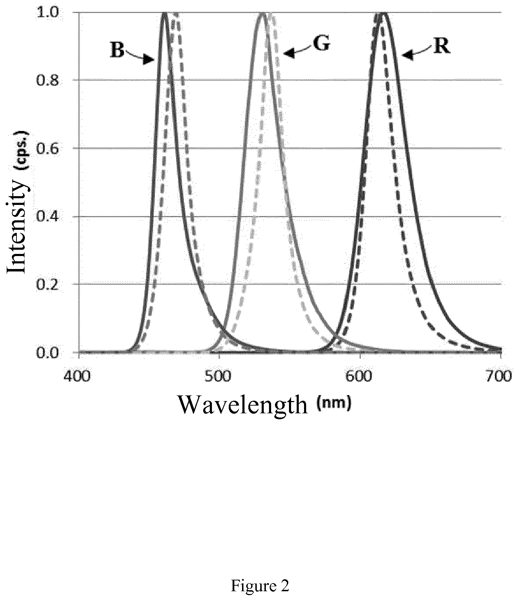

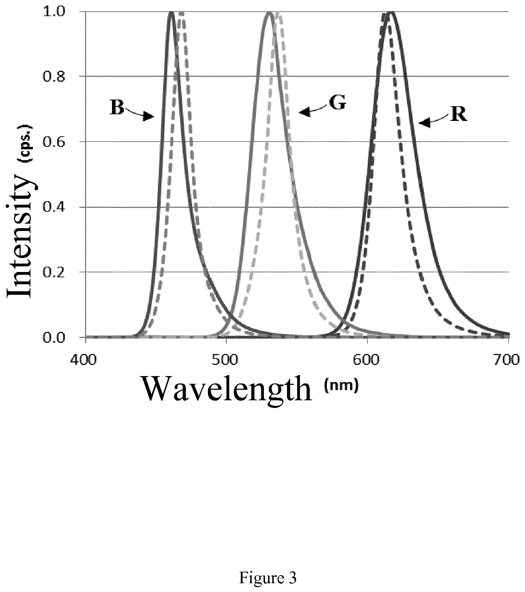

Figure 2 shows spectrograms of OLEDs of a first embodiment to a third embodiment and a first comparative example to a third comparative example of the present disclosure, and Figure 3 shows spectrograms of OLEDs of a fourth embodiment to a sixth embodiment and a first comparative example to a third comparative example of the present disclosure. Group B of curves represent spectrograms of OLEDs that emit blue lights according to the embodiments and the comparative examples, dashed curves are spectrograms of the embodiments, and solid curves are spectrograms of the comparative examples. Group G of curves represent spectrograms of OLEDs that emit green lights according to the embodiments and the comparative examples, dashed curves are spectrograms of the embodiments, and solid curves are spectrograms of the comparative examples. Group R of curves represent spectrograms of OLEDs that emit red lights according to the embodiments and the comparative examples, dashed curves are spectrograms of the embodiments, and solid curves are spectrograms of the comparative examples.

The distribution of each group of curves shown in Figures 2 and 3 demonstrate that, compared with the comparative examples, the OLEDs according to the embodiments of the present disclosure may not only improve the color purity, but also effectively suppress blue and violet lights that do harm to human bodies. blue lights of 435nm or shorter may be suppressed by 30%, and blue lights of 438nm or shorter may be suppressed by 40%.

Experimental results of OLEDs of other embodiments of the present disclosure are similar to those shown in Figures 2 and 3, and the description of the relevant experimental results will not be repeated herein.

The terms used in the present disclosure are of the meanings

commonly understood by those skilled in the art, unless defined otherwise.

The embodiments described in the present disclosure are merely for illustration purpose, not for limitation of the protective scope of the present disclosure. Therefore, the present disclosure is not limited to the above embodiments, but defined by the claims.

## Claims

1. An organic electroluminescent device, comprising:
a first electrode layer (1) formed on a substrate;
an organic functional layer (2), disposed on the first electrode layer (1); and
a second electrode layer (3), disposed on the organic functional layer (2);
wherein, the organic electroluminescent device further comprises:
an inorganic layer (5), disposed on the second electrode layer (3), wherein the inorganic layer (5) is a titanium dioxide layer or a silicon carbide layer, and a thickness of the inorganic layer (5) is 10nm∼20nm; and
a cover layer (4), disposed between the second electrode layer (3) and the inorganic layer (5), wherein the cover layer (4) is formed of organic material, and
**characterized in that**, the thickness of the cover layer (4) is 40nm∼80nm, such that micro-cavity structures of the inorganic layer (5) and the organic material together improve color purity of the organic electroluminescent device and suppress blue and violet lights that do harm to human eyes.

2. The organic electroluminescent device of claim 1, wherein the thickness of the inorganic layer (5) is 15nm.

3. The organic electroluminescent device of claim 1, wherein the organic material of the cover layer (4) is selected from Alq3, Bphen or BCP.

4. The organic electroluminescent device of any one of claims 1-3, wherein the organic functional layer (2) comprises a hole injection layer, a hole transport layer, a light emitting layer, an electron transport layer and an electron injection layer disposed sequentially, and the hole injection layer is disposed on the first electrode layer (1).

5. The organic electroluminescent device of claim 4, wherein the first electrode layer (1) is selected from an indium tin oxide layer, an indium zinc oxide layer, a tin oxide layer or a zinc oxide layer.

6. The organic electroluminescent device of claim 4, wherein the second electrode layer (3) is a metal electrode, an alloy electrode or a composite electrode of metal fluoride and metal.

7. The organic electroluminescent device of claim 6, wherein the metal is selected from lithium, magnesium, aluminum, calcium, strontium or indium.

8. The organic electroluminescent device of claim 6, wherein the alloy is alloyed by one of lithium, magnesium, aluminum, calcium, strontium and indium and one of copper, gold and silver.

9. A display, comprising an organic electroluminescent device of any one of claims 1-8.

## Patentansprüche

1. Organische elektrolumineszente Vorrichtung, aufweisend:
eine erste Elektrodenschicht (1), die auf einem Substrat ausgebildet ist;
eine organische funktionelle Schicht (2), die auf der ersten Elektrodenschicht (1) angeordnet ist; und
eine zweite Elektrodenschicht (3), die auf der organischen funktionellen Schicht (2) angeordnet ist;
wobei die organische elektrolumineszente Vorrichtung ferner aufweist:
eine anorganische Schicht (5), die auf der zweiten Elektrodenschicht (3) angeordnet ist, wobei die anorganische Schicht (5) eine Titandioxidschicht oder eine Siliziumkarbidschicht ist, und eine Dicke der anorganischen Lage (5) 10 nm ~ 20 nm beträgt; und
eine Deckschicht (4), die zwischen die zweite Elektrodenschicht (3) und die anorganische Schicht (5) angeordnet ist, wobei die Deckschicht (4) aus organischem Material gebildet ist, und
**dadurch gekennzeichnet, dass** die Dicke der Deckschicht (4) 40 nm ∼ 80 nm beträgt, so dass Mikrohohlraum-Strukturen der anorganischen Schicht (5) und das organische Material zusammen die Farbreinheit der organischen elektrolumineszenten Vorrichtung verbessern und blaue und violette Lichtanteile unterdrücken, die für das menschliche Auge schädlich sind.

2. Organische elektrolumineszente Vorrichtung nach Anspruch 1, wobei die Dicke der anorganischen Schicht (5) 15 nm beträgt.

3. Organische elektrolumineszente Vorrichtung nach Anspruch 1, wobei das organische Material der Deckschicht (4) aus Alq3, Bphen oder BCP ausgewählt ist.

4. Organische elektrolumineszente Vorrichtung nach einem der Ansprüche 1 bis 3, wobei die organische funktionelle Schicht (2) der Reihe nach angeordnet eine Lochinjektionsschicht, eine Lochtransportschicht, eine Licht emittierende Schicht, eine Elektronentransportschicht und eine Elektroneninjektionsschicht aufweist, und die Lochinjektionsschicht auf der ersten Elektrodenschicht (1) angeordnet ist.

5. Organische elektrolumineszente Vorrichtung nach Anspruch 4, wobei die erste Elektrodenschicht (1) aus einer Indium-Zinnoxid-Schicht, einer Indium-Zinkoxid-Schicht, einer Zinnoxid-Schicht oder einer Zinkoxid-Schicht ausgewählt ist.

6. Organische elektrolumineszente Vorrichtung nach Anspruch 4, wobei die zweite Elektrodenschicht (3) eine Metallelektrode, eine Legierungselektrode oder eine Verbundelektrode aus Metallfluorid und Metall ist.

7. Organische elektrolumineszente Vorrichtung nach Anspruch 6, wobei das Metall aus Lithium, Magnesium, Aluminium, Calcium, Strontium oder Indium ausgewählt ist.

8. Organische elektrolumineszente Vorrichtung nach Anspruch 6, wobei die Legierung aus einem Element von Lithium, Magnesium, Aluminium, Calcium, Strontium und Indium und einem Element von Kupfer, Gold und Silber legiert ist.

9. Bildschirm, aufweisend eine organische elektrolumineszente Vorrichtung nach einem der Ansprüche 1 bis 8.

## Revendications

1. Dispositif électroluminescent organique, comprenant :
une première couche d'électrode (1) formée sur un substrat ;
une couche organique fonctionnelle (2), disposée sur la première couche d'électrode (1) ; et
une seconde couche d'électrode (3), disposée sur la couche organique fonctionnelle (2) ;
le dispositif électroluminescent organique en outre comprenant :
une couche inorganique (5), disposée sur la seconde couche d'électrode (3), la couche inorganique (5) étant une couche de dioxyde de titane ou une couche de carbure de silicium, et une épaisseur de la couche inorganique (5) étant 10 nm ∼ 20 nm ; et
une couche de recouvrement (4), disposée entre la seconde couche d'électrode (3) et la couche inorganique (5), la couche de recouvrement (4) étant formée d'un matériau organique, et
**caractérisées en ce que** l'épaisseur de la couche de recouvrement (4) est 40 nm ∼ 80 nm, de telle manière que des structures de microcavités de la couche inorganique (5) et le matériau organique ensemble améliorent la pureté de couleur du dispositif électroluminescent organique et suppriment des lumières bleues et violettes qui sont nocives pour les yeux humains.

2. Dispositif électroluminescent organique selon la revendication 1, dans lequel l'épaisseur de la couche inorganique (5) est 15 nm.

3. Dispositif électroluminescent organique selon la revendication 1, dans lequel le matériau organique de la couche de recouvrement (4) est choisi parmi Alq3, Bphen ou BCP.

4. Dispositif électroluminescent organique selon l'une quelconque des revendications 1 à 3, dans lequel la couche organique fonctionnelle (2) comprend une couche d'injection de trous, une couche de transport de trous, une couche émettrice de lumière, une couche de transport d'électrons et une couche d'injection d'électrons, disposées à la suite, et la couche d'injection de trous est disposée sur la première couche d'électrode (1).

5. Dispositif électroluminescent organique selon la revendication 4, dans lequel la première couche d'électrode (1) est choisie parmi une couche d'oxyde d'indium-étain, une couche d'oxyde d'indium-zinc, une couche d'oxyde d'étain et une couche d'oxyde de zinc.

6. Dispositif électroluminescent organique selon la revendication 4, dans lequel la seconde couche d'électrode (3) est une électrode en métal, une électrode en alliage ou une électrode composée d'un fluorure de métal et un métal.

7. Dispositif électroluminescent organique selon la revendication 6, dans lequel le métal est choisi parmi le lithium, le magnésium, l'aluminium, le calcium, le strontium ou l'indium.

8. Dispositif électroluminescent organique selon la revendication 6, dans lequel l'alliage est formé d'un élément parmi le lithium, le magnésium, l'aluminium, le calcium, le strontium et l'indium et un élément parmi le cuivre, l'or et l'argent.

9. Affichage, comprenant un dispositif électroluminescent organique selon l'une quelconque des revendications 1 à 8.
